(19) Europäisches Patentamt
European Patent Office
Office européen des brevets

(11) Publication number: 0 112 005 B1

(12) # EUROPEAN PATENT SPECIFICATION

(45) Date of publication of patent specification: 20.01.88

(21) Application number: 83306374.6

(22) Date of filing: 20.10.83

(51) Int. Cl.[4]: **C 08 F 283/00**, C 08 F 299/06, C 08 G 18/67, H 05 K 5/06, H 05 K 3/28, C 08 G 18/42, C 08 G 18/48

(54) **Conformal coating and potting system.**

(30) Priority: 12.11.82 US 441164
12.11.82 US 441165
31.08.83 US 528286

(43) Date of publication of application:
27.06.84 Bulletin 84/26

(45) Publication of the grant of the patent:
20.01.88 Bulletin 88/03

(84) Designated Contracting States:
AT BE CH DE FR GB IT LI NL SE

(56) References cited:
US-A-3 396 210
US-A-3 968 089
US-A-4 097 677
US-A-4 131 602
US-A-4 145 503
US-A-4 174 307
US-A-4 180 645
US-A-4 305 854

(73) Proprietor: **LOCTITE CORPORATION**
**705 North Mountain Road**
**Newington, Connecticut 06111 (US)**

(72) Inventor: **Nativi, Larry A.**
**126 Ridgewood Drive**
**Rocky Hill Connecticut 06067 (US)**
Inventor: **Kadziela, Kris**
**190 Jerry Road**
**East Hartford Connecticut 06118 (US)**

(74) Representative: **Marchant, James Ian et al**
**Elkington and Fife High Holborn House**
**52/54 High Holborn**
**London WC1V 6SH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention concerns polymerizable compositions which have their primary utility in the area of coatings and sealants. The invention has particular utility in the area of conformal coatings for printed circuit boards and pottings for electrical and electronic components and will be described in connection with such utility, although other uses are contemplated.

Printed circuit boards and electrical and electronic components may be coated or potted with a protective film to avoid or at least minimize degradation in electrical performance due to contamination. The most damaging, and usually the most prevalent contaminant generally is considered to be moisture or humidity. Excessive moisture or humidity will drastically lower insulation resistance between conductors, accelerate high-voltage breakdown and dendritic growth, and corrode conductors. Other contaminants which may damage printed circuit boards and components include various chemicals which may be residues of the manufacturing process such as fluxes, organic solvents, release agents, metal particles and marking inks, and contaminants which inadvertently may be deposited by human handling such as body greases, fingerprints, cosmetics and food stains. Ambient operating conditions may also contribute a variety of contaminants such as salt spray, dirt and dust, oil, fuel, acid, corrosive vapor and fungus. Although the list of possible contaminants is almost endless, in all but the most severe cases, their destructive action effectively can be eliminated by provision of a good conformal coating.

In addition to providing protection from contaminants, conformal coatings and pottings also provide a certain degree of protection to mechanical shock, vibration and tampering.

Various conformal coating and potting systems are known in the art and are available commercially. Each has its advantages and disadvantages. One such prior art conformal coating and potting system is based on acrylics. Acrylics make excellent coating and potting systems from a production standpoint because they readily may be applied by spraying, dipping or brushing. Acrylic coatings and pottings have desirable electrical and physical properties and are fungus resistant. Additional advantages of acrylic coatings and pottings include long life, low or no exotherm during cure, and little or no shrinkage during cure. However, acrylic coatings and pottings typically are formed by solvent evaporation and reach optimum physical characteristics during cure typically in a matter of minutes. Conventional acrylic coatings and pottings are soluble in chlorinated solvents such as trichloroethane or methylene chloride.

Another prior art conformal coating and potting system is based on polyurethanes. Polyurethanes are available as either single or two-component systems. Polyurethane coatings and pottings offer excellent humidity and chemical resistance and good dielectric properties. Single-component urethanes are relatively easy to apply and exhibit relatively long working pot life. However, single-component polyurethanes typically require a curing time of three to ten days at room temperature to reach optimum physical characteristics. Two-component polyurethanes typically achieve optimum cure at elevated temperatures within one to three hours, but exhibit relatively short working pot life. Also, surface preparation of substrate boards and components prior to application of polyurethane based coatings and pottings is important, since even minute quantities of moisture on a substrate board or component could produce blistering under humid conditions. Blisters, in turn, may lead to electrical failures and mandate costly rework. Polyurethane coatings and pottings are insoluble in most common solvents, which is a drawback to rework. Thus, repair of a polyurethane coated board or potted components requires a corrosive stripper to remove effectively all traces of the polyurethane film. However, extreme caution must be exercised when such a stripper is used, because the stripper also may corrode metallic surfaces on the board or component.

Expoxy resin systems also have been employed by the prior art for conformal coatings and pottings. Epoxy resins are available as two component systems only. Epoxy resin coatings and pottings provide good humidity resistance and high abrasive and chemical resistance. However, epoxy resins are virtually impossible to remove chemically for rework because any stripper that will attack the coating also will attack materials commonly used in making the electronic components and the epoxy-glass of printed circuit boards as well. Thus, the only effective way to repair an epoxy resin coated board or potted component is to burn through the epoxy coating with a hot knife or soldering iron. However, burning introduces a cosmetic defect which is unacceptable to many consumers. Moreover, epoxy resins shrink somewhat during cure. Accordingly, a buffer material must be placed around fragile electronic components to prevent fracturing from shrinkage. Curing of epoxy systems can be accomplished in one to three hours at elevated temperature, or four to seven days at room temperature. Epoxy resins exhibit a relatively short working pot life which is an additional disadvantage.

Silicone resins also have been employed by the prior art for conformal coating and pottings. Silicone resin coatings and pottings provide high humidity and corrosion resistance along with high temperature resistance which makes silicone resins preferred for coating and potting assemblies that contain high heat-dissipating components such as power resistors. However, silicone resins are relatively thick making them somewhat difficult to apply. Moreover, silicone resins require a relatively long cure, and repairability is difficult since silicone resins once cured are essentially insoluble, and cannot be vaporized with the heat of a soldering iron. Accordingly, the only effective way to repair a silicone resin coated circuit board or potted component is to mechanically remove the coating.

The prior art also has employed polyimides for conformal coatings and pottings. Polyimide coatings

and pottings provide high-temperature, moisture and chemical resistance over extended periods of time. However, polyimide coatings require high temperature cure (one to three hours at 200 to 250°C) which could damage heat sensitive electronic components, and this requirement severely limits the use fo polyimide coating systems. Also, since polyimides are high-temperature, moisture and chemical resistant, the only effective way to repair a polyimide coated board or potted component is to mechanically remove the coating.

Diallyl phthalate varnishes also have been proposed by the prior art for conformal coatings and pottings, and provide excellent high temperature and chemical resistance. However, diallyl phthalate varnishes require high temperature cure (approximately 150°C) which severely limits their use. And, diallyl phthalate coatings and pottings also typically must be mechanically removed to permit repair.

The preceeding discussion of background in the art of conformal coating circuit boards is taken largely from *Printed Circuits Handbooks,* Clyde F. Coombs, Jr., Editor, McGraw Hill Book Company, Second Edition (1979).

As thus is apparent from the above discussion, none of the currently available conformal coatings and pottings are completely satisfactory since all prior art conformal coatings and pottings at best are a tradeoff of preferred application characteristics (i.e., processing speed, ease of application, pot life and cure conditions), preferred physical characteristics, (i.e., electrical properties, temperature, chemical and moisture resistance), and repairability.

It is thus a primary object of the present invention to provide an improved conformal coating and potting system, i.e. method and materials, which overcomes the aforesaid and other disadvantages of the prior art.

Other objects of the present invention are to provide an improved composition for conformal coating printed circuit board assemblies and potting electrical and electronic components which compositions demonstrate extended pot life and ease of application, rapid try-to-touch cure, good electrical properties, superior adhesion and abrasion resistance, excellent high temperature, chemical and moisture resistance, and ease of repairability.

Generally, the foregoing and other objects of the invention are achieved by the provision of an ultraviolet (hereinafter "uv") curable polymerizable coating and potting system having a secondary cross-linking curing mechanism built in. More specifically, in accordance with the present invention the polymerizable system is a one component coating system comprising at least one urethane-acrylate or methacrylate, an acrylate or methacrylate compound containing an allylic group, a non-allylic acrylate or methacrylate diluent, a polymerization initiator of the photo-initiator type, and metal-drier. A particular feature and advantage of the invention is that the uv radiation cure produces extremely rapid try-to-the-touch cure of all exposed areas of the coating thereby permitting substantially immediate handling of the coated products and maintainance of the shape of the coating which might otherwise sag and creep, while secondary curing which occurs by cross-linking through the allylic bond of the mono or polyfunctional reactive acrylate or methacrylate diluent provides substantially complete cure of unexposed (shadow) areas of the coating under conditions of ambient temperature and humidity.

For a fuller understanding of the nature and objects of the present invention, reference should be made to the following detailed description of the invention taken in connection with the accompanying examples.

The terms "liquid" and "solid" or "dry-to-the-touch" as used herein with reference to physical properties of the materials are to be understood as to be referring to such properties as they exist under conditions as may be specified. For example, the term "liquid" refers to a physical state wherein a material is readily flowable while the terms "solid" and "dry-to-the-touch" are to be understood as referring respectively to physical states wherein a material is resistant to change in shape and is without free surface moisture or surface tackiness.

The urethane-acrylates or methacrylates employed in the coating and potting system of the instant invention preferably comprise polyester-urethane-acrylates formed by reacting a polyester diol with a diisocyanate, and reacting the resulting product with a polymerizable acrylic or methacrylate acid ester. The preferred polyester diol is manufactured by the Inolex Company under the tradename Inolex 1400—120. This polyester diol is formed by reaction of neopentyl glycol and 1,6-hexanediol with adipic acid. Other polyester diols useful are formed by the reaction of neopentyl glycol and a diol of more than 3 carbon atoms, e.g., 1,4-butanediol with adipic acid. The preferred diisocyanate is toluene diisocyanate (TDI) although other relatively low molecular weight diisocyanates of the general formula:

$$(O{=}C{=}N)_2R \qquad (I)$$

wherein R is a $C_{2-20}$ alkylene, alkenylene or cycloalkylene radical or a $C_{6-40}$ arylene, alkarylene or aralkylene, are useful.

The reaction ratio of the equivalent weights of the polyester diol to the diisocyanate should generally be in the range of about 1.0 of polyester diol to about 1.7 to about 2.2 of diisocyanate. The preferred reaction ratio is 1.0 equivalents of the polyester diol for every 1.9 equivalents of diisocyanate. This preferred reaction ratio is particularly important to the properties of the final composition. The 1:1.9 ratio yields a composition with a chemical structure having a high degree of flexibility and stability. The copolymer formed is generally of a random copolymer structure. This copolymer product is then reacted

with an hydroxyl-containing acrylate or methacrylate ester monomer, producing acrylate end-capping. The useful range of equivalents of the ester monomers is about 0.9 to about 3.0, the preferred being in the range of 1.6 to 2.0, and the most preferred being 1.8 equivalents.

The polymerizable acrylate and methacrylate ester monomers used to cap the polyester diisocyanate reaction product may be mono- or difunctional. Mono-functional monomers are preferred. Those monofunctional monomers found most effective are selected from the group consisting of hydroxyalkyl acrylates and methacrylates, amino alkyl acrylates and methacrylates. The most preferred polymerizable ester monomers are hydroxyethyl methacrylate and hydroxypropyl methacrylate.

Additional monofunctional polymerizable ester monomers deemed useful are represented by the following formula:

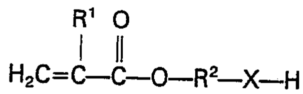 wherein X is —O— or 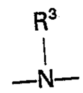 (II)

$R^3$ is hydrogen or lower alkyl of 1 to 7 carbon atoms; $R^1$ is selected from the group consisting of hydrogen, chlorine and methyl and ethyl radicals; and $R^2$ is a divalent organic radical selected from the group consisting of lower alkylene of 1—8 carbon atoms, phenylene and naphthylene.

Suitable hydroxy- or amine-containing materials are exemplified by, but not limited to, such materials as hydroxyethyl acrylate, hydroxyethyl methacrylate, aminoethyl methacrylate, 3-hydroxypropyl methacrylate, aminoethyl methacrylate, hydroxyhexyl acrylate, t-butylaminoethyl methacrylate, hydroxyoctyl methacrylate, and the monoacrylate or monomethacrylate esters of bisphenol-A, the fully hydrogenated derivative of bisphenol-A, cyclohexyl diol, and polyethyleneglycol methacrylate.

Preferably but not necessarily the end-capping reaction will be accomplished in the absence of diluents. In the event diluents are employed they preferably will comprise mono or polyfunctional reactive acrylate or methacrylate compounds.

The mono or polyfunctional reactive acrylate or methacrylate reactive diluents employed in the coating and potting system of the present invention comprise allylic-bond containing acrylates or methacrylates of the formula:

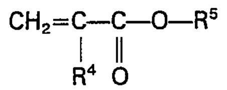 (III)

in which $R^4$ is a radical selected from the group consisting of hydrogen and lower alkyl of 1 to 4 carbon atoms, and $R^5$ is an organic radical containing at least one allylic bond and does not contain any group which may adversely affect the coating system for purposes disclosed herein. Preferably $R^5$ will consist of an allylic-bond containing aliphatic or substituted aliphatic carbon ring structure of which dicyclopentenyloxyethyl is presently preferred. Other allylic-bond containing carbon ring structures such as dicyclopentenyl which is given as exemplary may also be advantageously employed.

Other non-allylic reactive diluents also may be included in the coating composition. Such diluents preferably are acrylate or methacrylate compounds of which hydroxyethyl methacrylate (HEMA) is the most preferred compound.

The urethane acrylate or methacrylate typically comprises about 20 to about 50% by weight of the reactive mixture, preferably will comprise about 20 to about 30% by weight, while the allylic group containing acrylate or methacrylate and the non-allylic reactive diluent typically comprise, respectively, about 10 to about 50% and about 60 to about 20% by weight of the reactive mixture; most preferably each will comprise about 35% by weight of the reactive mixture.

Incorporated into the coating and potting system of the present invention are appropriate metal-driers, the purpose of which will be discussed in detail hereinafter. Useful metal-driers include salts of metals with a valence of two or greater and unsaturated organic acids. Amongst suitable compounds are mentioned the linoleates, naphthenates and resinates of cobalt, manganese, serium, lead, chromium, iron, nickel, uranium and zinc. The metal driers are usually employed in concentrations of less than between about 0.01 and five percent by weight of the coating system.

The polymerization initiators useful in accordance with the present invention preferably comprise ultra-violet (hereafter "uv") activated free-radical generators and typically may be employed in amounts of about 1% to about 10% by weight of the coating and potting composition, although greater or lesser amounts of polymerization initiators may be employed. Many uv activated polymerization initiators are known in the art and may be advantageously employed in the invention. For example, the uv activated initiators may be selected from metal carbonyls of the formula $M_x(CO)_y$ wherein M is a metal atom, x is 1 or 2, and y is an integer determined by the total valence of the metal atoms, generally 4 to 10. The preferred uv activated initiators are selected from (a) $C_{1-16}$ straight or branched chain alkyl diones; and (b) carbonyl compounds of the general formula $R^5(CO)R^6$ wherein $R^5$ is a $C_{1-10}$ alkyl, aryl, aralkyl or alkaryl group, and $R^6$ is $R^5$ or hydrogen. In addition, $R^5$ or $R^6$ can contain any substituents which do not adversely affect the

compound in serving its function. For example, $R^5$ or $R^6$ can be alpha-substituted with an alkyl, aryl, alkaryl, alkoxy or aryloxy radical, or with an amino or a mono- or dialkylamino derivative thereof, each of the above substituents containing up to about six carbon atoms. In addition, $R^5$ and $R^6$ taken together with carbonyl group form an aromatic or heterocyclic ketone containing up to about 16 carbon atoms.

It is useful, but not required to incorporate an adhesion promoter into the coating and potting system. The adhesion promoters may be chosen from any of those commonly known to the person reasonably skilled in the art. Two types of promoters are preferred. The first type consists of mono- and dicarboxylic acids which are capable of copolymerizing with the acrylate or methacrylate reactive diluent. The preferred species of these classes are methacrylic and acrylic acid. Such acids are used in proportions of 1—20% by weight of coating and potting system, preferably in proportion of 1—10 to 1—15%. The second preferred type of adhesion promoter is of the well-known silane type, present in the composition in proportion of 1—10% by weight of the coating and potting system.

Also optional, but recommended, are the inclusion of one or more chelators, cross-linking agents and/or polymerization inhibitors. Chelators and inhibitors are effective in amounts of about 0.1 to about 1% by weight of the coating and potting system. Ethylenediamine tetra-acetic acid and its sodium salt ($Na_4EDTA$), 1,1-ethylenebis-nitril methylidyne dipyridine and the class of beta-diketones are generally the most effective and are preferred. Cross-linking agents, optionally present in amounts from about zero to about 10% by weight of the coating and potting system, include such compounds as copolymerizable dimethacrylates.

The inhibitor concentration left over in the monomers from manufacture is often high enough for good stability. However, to ensure maximum shelf life, the proportions mentioned above (about 0.1 to about 1% by weight of the coating and potting system) are recommended. Of those inhibitors which have been found of adequate utility is the group consisting of hydroquinones, benzoquinones, naphthoquinones, phenanthraquinones, anthraquinones, and substituted compounds of any of the foregoing. Additionally, various phenols can be employed as inhibitors, the preferred one being 1,6-di-tert-butyl-4-methyl phenol.

The amount of thickness, viscosity, or thixotropy desired can be varied in accordance with the particular application required. Thickeners, plasticizers, diluents, and various other reagents common to the art can be employed in any reasonable manner to produce the desired characteristics.

It also is optional, but recommended, that surfactants be present in the coating and potting system for optimum performance. Selection of suitable surfactants is a matter of simple experimentation. Obviously the surfactant must be soluble in the polymer composition and should be non-reactive with the isocyanate-capped prepolymer. The surfactants may be anionic materials such as the petroleum sulfonates having the formula:

$$(C_nH_{2n-10}SO_3)_xMe \qquad \text{(VIII)}$$

wherein n is more than 20 and Me is a metal of valence x. Such materials are sold by, among others, Witco Chemical Corp., New York, New York, under the trademark "Alconate" 80, and by the Penreco Division of Penzoil, Butler, Pennsylvania, under the trademark "Pertrobase."

Another suitable anionic type comprises the sodium alkyl or alkylaryl sulfonates having the formula:

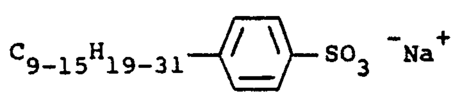

(IX)

Such materials are sold by E. I. duPont de Nemours & Co., Wilmington, Delaware, under the trademarks "Alkanol" 189—S and "DW" and the trademark "Duponol," and by Union Carbide Corp., New York, New York, under the trademark "Tergitol" (numerical series). Still another useful anionic class is the sulfonated ethoxylated types sold as the "Alipal" series by GAF Corp., New York, New York, and as "Neodol" 25—35 by Shell Chemical Co., Houston, Texas.

Non-ionic surfactants such as Union Carbide L—5320 also may be usefully employed in the inventive compositions.

Surfactant concentration will depend in any given case upon the particular surfactant and reactive diluent being used. Optimization will be a matter of routine experimentation within the skill of the art. Ordinarily, for anionic surfactants, however, minimum concentration of about 0.25 percent surfactant by weight of the coating and potting system will be needed to achieve an acceptable degree of emulsifiability, and a concentration of at least about 0.5 percent usually will be preferred. The maximum surfactant concentration will usually be about ten percent since above this level the surfactant may begin to interfere with the properties of the coating and potting system by adversely affecting, for example, its cure rate, stability or the cured products. As a practical matter, an upper concentration limit of about five percent, is usually satisfactory. For non-ionic surfactants, the optimum concentration may be lower, typically around 0.1% or less by weight of the total coating and potting system.

It is frequently desirable to add low levels, such as up to about 500 parts per million by weight, of a free-radical or uv stabilizer, many of which are known in the art, to prevent spurious polymerization of the composition prior to the time of its intended use. Suitable free-radical stabilizers are hydroquinone, p-benzoquinone, butylate of hydroxytoluene, and butylate of hydroxyanisole.

The coating and potting systems of the present invention are designed primarily as a uv curing product; however, due to the configuration of many circuit boards and electrical and electronic components there are shadow areas that cannot be cured by uv light. To overcome this deficiency, a second curing mechanism has been built into the coating and potting system. More specifically, in accordance with the invention, the overall curing mechanisms are as follows:

(1) uv light polymerizes the acrylate or methacrylate species to provide fixture to the coating or potting; and

(2) the allylic bonds then undergo cross-linking in the presence of the metal-dryers. Cross-linking of the allylic bonds typically provides ultimate physical properties and complete cure to the substrate of unexposed areas of the coating or potting in twenty-four hours or less.

Example I

A nitrogen-swept, four-necked uv shielded resin kettle equiped with a stainless steel stirrer, nitrogen inlet tube, thermometer, condensor and entrance port, was heated to approximately 40°C., 165 grams of MOBAY TDI toluene diisocyanate added, and 460 grams of 1,6-hexanediol/neopentyl glycol adipate (Inolex 1400—120 polyester, Inolex Company, Philadelphia, PA) was slowly added over 20 minutes. At the completion of the polyester addition, heating was continued with stirring (40 to 45°C temperature) for one hour, followed by two hours heating with stirring at 100°C. Upon completion of the three hour reaction period, the bath temperature was lowered to 50°C, and 230 grams of hydroxyethylmethacrylate was added. The reaction mixture was then heated, maintained at 50°C and stirred for two hours at that temperature.

The reaction mixture was permitted to return to room temperature. To 170 grams of the product resin were added the following ingredients, with stirring: 275 grams dicyclopentenyloxyethyl methacrylate; 29 grams acrylic acid; 5.5 grams glycidoxypropyltrimethoxysilane; 20 grams Ciba-Geigy Igacure 651 dimethoxy-2-phenyl-acetophenone; 0.5 grams Union Carbide L—5320 silicone surfactant, and 1.5 grams 3M Company Fluorad FC 430 leveling agent. The mixture was stirred until all ingredients were dissolved. The resulting solution contained about 34 percent concentration of polyester-urethane-methacrylate resin (PEUMA).

A mixture containing 66.4 percent of the above resin solution, 33.2 percent of hydroxyethylmethacrylate and 0.3 percent of a 6 percent solution of Cobalt napthenate was used in the following working example.

Working Example

The resulting solution was sprayed onto the top side surface (i.e. component side surface) of a printed circuit board. Cure of the coating was effected by exposing the boards to uv radiation (3650 angstroms, 1 angstrom = $1 \times 10^{-10}$m), 60,000 microwatts per square centimeter). Those areas of the coating exposed to uv radiation were solid and dry to the touch within 10—45 seconds. Areas in the shadow of components, i.e. not receiving direct uv radiation, however, were observed to be wet to the touch, but found to be fully cured after standing at ambient temperature and humidity conditions for 24 hours. Circuit boards were sliced through shadow areas after 24 hours and the coating was found to be fully cured to the board.

Coated boards were placed on a rack in a stainless steel tank, and 500 grams of water added to the bottom of the tank. The tank was closed, sealed, and heated to a temperature of 115°C. After heating for 40 hours, the tank was allowed to cool. The tank was then opened, and the boards removed and examined. No visible blistering or other evidence of coating failure was observed.

Example II

The procedure of Example I was repeated except an equal amount of Alcolac SIPOMER DCPM dicyclopentenyl methacrylate was employed in place of the dicyclopentenyloxyethyl methacrylate. Similar results to Example I were obtained.

Example III

The procedure of Example I was repeated except an equal amount of dicyclobutadiene methacrylate was employed in place of the dicyclopentenyloxyethyl methacrylate.

As will be appreciated the foregoing invention provides novel and improved coating systems for conformal coating and potting printing circuit boards and electrical and electronic components and the like. The coating and potting systems may be applied to the circuit board substrates or components by any convenient manner, for instance by brushing, dripping, rolling, dipping, etc. or by spraying (when suitably diluted). Moreover, the coating and potting systems cure through dual mechanisms including uv cure which permits fast fixture cure thereby achieving almost immediate dry-to-the-touch curing. However, unlike conventional uv cured products, the coating and potting systems of the present invention do not require full area irradiation to achieve full cure due to their built-in secondary cure mechanism. Moreover, the cured coatings and pottings have excellent adherence to plastics, metal, glass and wood, good abrasion resistance, and are hydrolytically stable and resistant to thermal cycling. The coating and pottings also are repairable, i.e., can be removed by selective solvents such as methyl ethyl ketone, and then replaced by brush or spray, and uv cured.

The invention has been described particularly with application to conformal coating circuit board

assemblies and to potting audio speaker cores. However, one skilled in the art would appreciate that the coating and potting systems may be applied to other electrical electronic components such as electrical transformers. Moreover, the coating and potting system is not limited to the use in the electronics field but may be employed in any industrial area where conformal protective coating and/or potting is desired.

**Claims**

1. A one-part coating composition, especially useful for conformal coating and potting, characterized by comprising, in combination,
(A) a polymerizable system comprising:
(a) at least one urethane-acrylate or urethane-methacrylate compound;
(b) an acrylate or methacrylate compound containing an allylic group;
(c) a non-allylic acrylate or methacrylate diluent; and
(d) a metal-drier; and,
(B) a polymerization initiator of the photo-initiator type.

2. The composition of Claim 1, characterized in that said urethane-acrylate or urethane-methacrylate compound comprises a polyester-urethane-acrylate or polyester-urethane-methacrylate.

3. The composition of Claim 2, characterized in that the polyester portion of said polyester-urethane-methacrylate comprises a polyester diol, said polyester diol preferably comprising the reaction product of neopentyl glycol and 1,6-hexanediol with adipic acid.

4. The composition of any of Claims 1 to 3, characterized by one or more of the following features:
(a) said non-allylic diluent comprises hydroxyethylmethacrylate;
(b) said metal-drier comprises a salt of a metal having a valence of at least two and an unsaturated organic acid, said metal-drier preferably being selected from the linoleates, naphthenates and resinates of cobalt, manganese, cerium, lead, chromium, iron, nickel, uranium and zinc, more preferably a cobalt naphthenate;
(c) said urethane-acrylate or urethane-methacrylate comprises about 20 to about 50% by weight of said composition;
(d) said non-allylic acrylate or methacrylate diluent comprises about 20 to 60% by weight of said coating composition;
(e) said allylic-group containing acrylate or methacrylate comprises about 10 to 50% by weight of said composition; and
(f) said allylic-group containing acrylate or methacrylate is selected from dicyclopentenyloxyethyl methacrylate and dicyclopentenyl methacrylate.

5. The composition of any of Claims 1 to 4 characterized by further comprising a surfactant.

6. A method of forming a uv curing polymerizable conformal coating or potting on a substrate wherein said substrate has one or more shadow areas, characterized by the steps in sequence of:
(1) providing a polymerizable composition comprising:
(i) at least one urethane-acrylate or urethane-methacrylate compound,
(ii) an allylic-group containing acrylate or methacrylate,
(iii) a non-allylic acrylate or methacrylate diluent,
(iv) a metal-drier, and
(v) a polymerization initator of the photo-initiator type.
(2) coating said substrate at least in part with said polymerizable composition;
(3) exposing said coated substrate to uv light of wave length and intensity to effect uv cure of exposed areas of said coating; and
(4) storing said coated substrate under conditions of temperature and humidity such as to promote curing of unexposed (shadow) areas of said coating through a built-in secondary cure mechanism.

7. A method according to Claim 6, characterized in that said substrate comprises an electrical or electronic component, if desired mounted on a circuit board and overshadowing areas of said circuit board.

8. An electrical or electronic component, if desired mounted on a circuit board, and covered at least in part with the cured composition of any of Claims 1 to 5.

**Patentansprüche**

1. Einkomponenten-Beschichtungsmasse, insbesondere verwendbar für das konturgetreue Beschichten und Vergiessen, dadurch gekennzeichnet, daß sie in Kombination aufweist,
(A) ein polymerisierbares System, das aufweist:
(a) wenigstens eine Urethan-Acrylat-oder Urethan-Methacrylat-Zusammensetzung;
(b) eine Acrylat- oder Methacrylat-Zusammensetzung die eine Allylgruppe enthält;
(c) ein Nicht-Allyl-Acrylat- oder Methacrylat-Verdünnungsmittel; und
(d) einen Metalltrockner; und
(B) einen Polymerisationsinitiator des Photo-Iniatortyps.

2. Masse nach Anspruch 1, dadurch gekennzeichnet, daß die Urethan-Acrylat- oder Urethan-Methacrylat-Zusammensetzung ein Polyester-Urethan-Acrylat oder Polyester-Urethan-Methacrylat aufweist.

3. Masse nach Anspruch 2, dadurch gekennzeichnet, daß der Polyesterteil des Polyester-Urethan-Methacrylats ein Polyesterdiol aufweist, wobei das Polyesterdiol vorzugsweise das Reaktionsprodukt von Neopentylglykol und 1,6-Hexandiol mit Adipinsäure aufweist.

4. Masse nach einem der Ansprüche 1 bis 3, gekennzeichnet durch ein oder mehrere der folgenden Merkmale:

(a) das Nicht-Allyl-Verdünnungsmittel weist Hydroxyethylmethacrylat auf;

(b) der Metalltrockner weist ein Salz eines Metalls von einer Wertigkeit von wenigstens zwei und einer Wertigkeit von wenigstens zwei und einer ungesättigten organischen Säure auf, wobei der Metalltrockner vorzugsweise aus Linolaten, Naphthenaten und Resinaten von Kobalt, Magnesium, Cer, Blei, Chrom, Eisen, Nickel, Uran und Zink ausgewählt ist, und vorzugsweise ein Kobaltnaphthenat ist;

(c) das Urethan-Acrylat oder Urethan-Methacrylat etwa 20 bis etwa 50% Gew.-% der Masse ist;

(d) das Nicht-Allylacrylat-oder Methacrylat-Verdünnungsmittel etwa 20 bis 60 Gew.% der Beschichtungsmasse ist;

(e) das Allyl-Gruppe enthaltende Acrylat oder Methacrylat etwa 10 bis 50 Gew.-% der Mass ist; und

(f) das Allyl-Gruppe enthaltende Acrylat oder Methacrylat aus Dicyclopentenyloxyethylmethacrylat und Dicyclopentenylmethacrylat gewählt ist.

5. Masse nach einem der Ansprüche 1 bis 4, dadurch gekennzeichnet, daß ferner ein oberflächenaktives Mittel vorgesehen ist.

6. Verfahren zur Herstellung einer UV-härtbaren, polymerisierbaren, konturgetreuen Beschichtung oder Vergiessung auf einem Substrat, bei dem das Substrat einen oder mehrere Schattenbereiche hat, gekennzeichnet durch die folgende Schrittfolge:

(1) Bereitstellen einer polymerisierbaren Masse, die aufweist:

(i) wenigstens eine Urethan-Acrylat- oder Urethan-Methacrylat-Zusammensetzung,

(ii) eine Allyl-Gruppe enthaltendes Acrylat oder Methacrylat,

(iii) ein Nicht-Allyl-Acrylat-oder Methacrylat-Verdünnungsmittel,

(iv) einen Metalltrockner, und

(v) einen Polymerisationsinitiator des Photoinitiatortyps;

(2) wenigstens teilweises Beschichten des Substrats mit der polymerisierbaren Masse;

(3) Aussetzen des beschichteten Substrats einem UV-Licht einer Wellenlänge und Intensität, um eine UV-Aushärtung der bestrahlten Bereiche der Beschichtung zu bewirken; und

(4) Lagern des beschichteten Substrats unter Temperatur-und Feuchtigkeitsbedingungen der Art, daß die Aushärtung der unbestrahlten (Schatten) Bereiche der Beschichtung durch einen eingebauten zweiten Aushärtungsmechanismus beschleunigt wird.

7. Verfahren nach Anspruch 6, dadurch gekennzeichnet, daß das Substrat ein elektrisches oder electronisches Bauteil ist, das gegebenenfalls auf einer gedruckten Schaltungsplatte angebracht ist und überschattende Bereiche der Schaltungsplatte umfaßt.

8. Elektrisches oder elektronisches Bauteil, das gegebenenfalls auf einer gedruckten Schaltungsplatte angebracht ist und das wenigstens teilweise mit der gehärteten Masse nach einem der Ansprüche 1 bis 5 überzogen ist.

**Revendications**

1. Une composition de revêtement et une partie, spécialement utile pour réaliser des revêtements et des encapsulations épousant les formes, caractérisé en ce qu'elle comprend, en combinaison,

(A) un système polymérisable comprenant:

(a) au moins un composé uréthane-acrylate ou uréthane-méthacrylate;

(b) un composé acrylate ou méthacrylate contenant un groupe allylique;

(c) un diluant acrylate ou méthacrylate non-allylique; et

(d) un siccatif dérivé d'un métal; et

(B) un initiateur de polymérisation du type photoinitiateur.

2. La composition de la revendication 1, caractérisée en ce que ledit composé uréthane-acrylate ou uréthane-méthacrylate comprend un polyester-uréthaneacrylate ou un polyester-uréthane-méthacrylate.

3. La composition de la revendication 2, caractérisée en ce quel la portion polyester dudit polyester-uréthane-méthacrylate comprend un polyester-diol, ce polyester-diol comprenant de préférence le produit de réaction de néopentyl glycol et de 1,6-hexanediol avec l'acide adipique.

4. La composition de l'une quelconque des revendications 1 à 3, caractérisée par une ou plusieurs des particularités suivantes:

(a) ledit diluant non-allylique comprend du méthacrylate d'hydroxyéthyle;

(b) ledit siccatif dérivé d'un métal comprend un sel d'un métal ayant une valence de deux et d'un acid organique insaturé, ce siccatif dérivé d'un métal étant de préférence choisi parmi les linoléates, naphténates et résinates de cobalt, manganèse, cérium, plomb, chrome, fer, nickel, uranium et zinc, en particulier un naphténate de cobalt;

(c) ledit uréthane-acrylate ou uréthane-méthacrylate constitue environ 20 à environ 50% en poids de ladite composition;

(d) ledit diluant acrylate ou méthacrylate non-allylique constitue environ 20 à 60% en poids de ladite composition de revêtement;

(e) ledit acrylate ou méthacrylate contenant un groupe allylique constitue environ 10 à 50% en poids de ladite composition; et

(f) ledit acrylate ou méthacrylate contenant un groupe allylique est choisi parmi le méthacrylate de dicyclopenténylоxyéthyl et le méthacrylate de dicyclopenténуle.

5. La composition de l'une quelconque des revendications 1 à 4, caractérisée en ce qu'elle comprend, en outre, un agent tensio-actif.

6. Un procédé pour former un revêtement ou une encapsulation, épousant les formes et duricissable par des rayons ultra-violets, sur un substrat ayant une ou plusieurs zones dans l'ombre, caractérisé en ce qu'il comprend, dans l'ordre, les étapes suiantes:

(1) fournir une composition polymérisable comprenant:

(i) au moins un composé uréthane-acrylate ou uréthane-méthacrylate,

(ii) un acrylate ou méthacrylate contenant un groupe allylique,

(iii) un diluant acrylate ou méthacrylate non-allylique,

(iv) un siccatif dérivé d'un métal, et

(v) un initiateur de polymérisation du type photo-initiateur;

(2) revêtir ledit substrat au moins en partie avec ladite composition polymérisable;

(3) exposer ledit substrat revêtu à de la lumière ultra-violette d'une longueur d'onde et d'une intensité assurant un durcissement par les U.V. des zones exposées dudit revêtement; et

(4) entreposer ledit substrat revêtu dans des conditions de température et d'humidité telles qu'elles favorisent un durcissement des zones non-exposées (dans l'ombre) dudit revêtement par un mécanisme de duricissement secondaire incorporé.

7. Un procédé selon la revendication 6, caractérisé en ce que ledit substrat comprend un composant électrique ou électronique, si désiré monté sur un panneau de circuit, et des zones dudit panneau de circuit qui font de l'ombre.

8. Un composant éléctrique ou électronique, si désiré monté sur un panneau de circuit, et recouvert au moins en partie de la composition durcie de l'une quelconque des revendications 1 à 5.